Europäisches Patentamt

European Patent Office

Office européen des brevets

(11) Numéro de publication: **0 032 087**
**B1**

(12) **FASCICULE DE BREVET EUROPEEN**

(45) Date de publication du fascicule du brevet: **02.05.85**

(21) Numéro de dépôt: **80401824.0**

(22) Date de dépôt: **18.12.80**

(51) Int. Cl.⁴: **H 01 C 7/22,** B 41 J 3/20,
H 01 C 17/06, H 01 C 17/24,
H 01 C 1/142, H 01 C 13/02

(54) **Plaquette de résistances en ligne à très faible pas.**

(30) Priorité: **04.01.80 FR 8000171**

(43) Date de publication de la demande:
**15.07.81 Bulletin 81/28**

(45) Mention de la délivrance du brevet:
**02.05.85 Bulletin 85/18**

(84) Etats contractants désignés:
**BE DE GB IT LU NL SE**

(56) Documents cités:
**EP-A-0 001 520**
**EP-A-0 021 833**
**FR-A-1 604 199**
**US-A-4 037 315**
**US-A-4 176 445**

(73) Titulaire: **THOMSON-CSF**
**173, Boulevard Haussmann**
**F-75379 Paris Cedex 08 (FR)**

(72) Inventeur: **Lacroix, Hervé**
**TOMSON-CSF SCPI 173, bld Haussmann**
**F-75360 Paris Cedex 08 (FR)**
Inventeur: **Val, Christian**
**THOMSON-CSF SCPI 173, bld Haussmann**
**F-75360 Paris Cedex 08 (FR)**
Inventeur: **Vergnolle, Claude**
**THOMSON-CSF SCPI 173, bld Haussmann**
**F-75360 Paris Cedex 08 (FR)**

(74) Mandataire: **Taboureau, James et al**
**THOMSON-CSF SCPI 173, Bld Haussmann**
**F-75379 Paris Cedex 08 (FR)**

Courier Press, Leamington Spa, England.

## Description

L'invention concerne les résistances en ligne à très faible pas et leurs procédés de réalisation sur des substrats solides.

De telles résistances sont utilisées d'une façon générale en électronique dans des systèmes répétitifs pour lesquels toutes les résistances ont la même valeur, mais plus particulièrement dans les dispositifs d'impression thermique tels que têtes d'impression dans un système de télécopie, de télématique ou pour des enregistreurs sur papier. De façon à être plus précis, l'exposé de l'invention s'appuie sur l'exemple d'une tête d'impression thermique pour imprimante dans laquelle chaque ligne de texte est formée par une succession d'environ 8 à 10 lignes de points eux-mêmes obtenus par une modification physicochimique du papier sous l'action de la chaleur dégagée par celles des résistances qui sont commandées à chaque ligne: un caractère est ainsi formé par un certain nombre de points et le caractère est d'autant plus précis et lisible que le nombre de points est plus élevé, et que par conséquent les dimensions des résistances sont petites. Selon les constructeurs le pas des résistances, et donc à peu de chose près leur largeur varie de 375 à 125 microns.

La réalisation pratique de telles barrettes de résistance présente de nombreuses difficultés technologiques liées au fait que:

— les résistances sont de très petites dimensions;
— elles sont très repprochées entre elles, leur pas étant très faible;
— chaque résistance comporte deux connexions, d'entrée et de sortie, rendant très dense le réseau des conducteurs qui relie la barrette thermique à l'électronique de commande.

Les résistances en ligne actuellement connues sont réalisées sous forme de petits rectangles résistifs alignés à quelques microns d'écart entre eux, chacun comportant deux conducteurs, l'ensemble de chaque résistance et de ses deux conducteurs étant séparé des ensembles voisins. Ceci nécessite une technologie très poussée pour la réalisation aussi bien des rectangles résistifs que des circuits souples de sortie, c'est-à-dire des supports isolants sur lesquels sont disposés les connexions, généralement en cuivre, doré aux extrémités, très proches les unes des autres et très nombreuses, de l'ordre du millier. La réalisation des connexions de sortie en or peut so faire par photogravure d'un dépôt uniforme d'or sur le support de la tête d'impression. Mais le dépôt de la pâte résistive, pour constituer chaque rectangle résistif, c'est-à-dire la résistance à proprement parler, atteint les limites possibles de la sérigraphie.

Le brevet US—A—4037 315 décrit une tête d'impression thermique dans laquelle les connexions d'accès aux résistances sont réalisées par sérigraphie: elles comprennent une unique plage métallique, d'un côté, et une pluralité de bandes métalliques perpendiculaires à la plage métallique, d'un autre côté. Entre ces deux systèmes de connexions, et le long de la plage métallique, est déposée une bande résistive assez large pour déborder légèrement sur les connexions métalliques et être en contact électrique avec elles. La bande résistive est alors découpée au laser en une pluralité d'éléments résistifs discrets, à raison d'une coupure au laser entre chaque paire de bandes métalliques.

L'ensemble des dépôts métalliques et résistif étant faits par sérigraphie, cette réalisation ne résout pas le problème d'un grand nombre de connexions d'accès, bandes métalliques fines, serrées à raison de 8 ou 10 par millimètre, et cependant, non court-circuitées entre elles, ce qui est très difficile à réaliser par sérigraphie. Disposer d'éléments résistifs discrets est intéressant, car cela améliore la définition, et donne une impression thermique plus nette que si la bande résistive n'est pas découpée, mais il est plus important que les connexions d'accès soient bien définies sur leurs bords, ce que ne permet pas la sérigraphie à si petite échelle.

En outre, la tête d'impression thermique décrite dans ce brevet US—A—4 037 315 comporte, d'un côté de la bande résistive, autant de connexions qu'il y a de résistances élémentaires, et de l'autre côté une plage métallique unique qui ne permet pas la commande par multiplexage, nécessaire pour augmenter la vitesse d'impression.

Les barrettes de résistance en ligne selon l'invention constituent un progrès dans la voie de la simplification de fabrication. En premier lieu les conducteurs sont alternés des deux côtés de la barrette résistive, chaque connexion étant commune à deux résistances, ce qui diminue de moitié le nombre des connexions. En second lieu les résistances et les conducteurs sont déposés sous forme d'une bande continue, laquelle est ensuite répartie et découpée en résistances élémentaires et en connexions par découpe des bandes conductrices et éventuellement découpe de la bande résistive pour ajustage.

De façon plus précise l'invention concerne deux réalisations d'une plaquette de résistances en ligne à très faible pas.

La première réalisation est une plaquette de résistances à très faible pas, groupées en deux séries interdigitées dans lesquelles elles sont connectées en parallèle, et munies d'autant de connexions électriques qu'il y a de résistances plus une, cette plaquette comprenant, supportées par un substrat isolant, rigide et plan, deux bandes métalliques parallèles et une bande résistive, disposée entre elles et en contact électrique avec elles, un sillon en forme de grecque traversant de façon répétée la bande résistive et pénétrant dans les bandes métalliques, y changeant de direction et séparant ainsi des plages du reste des dites bandes, lesdites plages servant de plages de connexions entre une résistance, découpée dans la bande résistive par le sillon en forme de grecque, et le circuit externe auquel elles sont reliées par un fil métallique de connexion.

La deuxième réalisation est une plaquette de résistances à très faible pas, connectées en série et munies d'autant de connexions électriques qu'il y a des résistances plus une, cette plaquette comprenant, supportées par un substrat isolant, rigide et plan, deux bandes métalliques parallèles et une bande résistive, disposée entre elles et en contact électrique avec elles, une première pluralité de sillons, parallèles entre eux, traversant la bande résistive et la première bande métallique, et une deuxième pluralité de sillons parallèles entre eux, traversant la bande résistive et la deuxième bande métallique, les sillons des première et deuxième pluralités de sillons étant interdigités, une résistance, ainsi découpée dans la bande résistive par les sillons étant connectée au circuit externe par deux connexions métalliques, respectivement en contact électrique avec les deux bandes métalliques.

L'invention et les avantages qu'on tire en seront mieux compris par la description qui va suivre de deux exemples de réalisation, lesquels s'appuient sur des figures qui représentent:

— figure 1, le schéma de résistances en ligne selon l'art classique;
— figure 2, le dessin d'implantation de résistances en ligne, selon un premier exemple de réalisation de l'invention;
— figure 3, le schéma électrique équivalent du dessin d'implantation du premier exemple de réalisation;
— figure 4, le dessin d'implantation de résistances en ligne, selon un deuxième exemple de réalisation de l'invention;
— figure 5, le schéma électrique équivalent du dessin d'implantation selon la deuxième exemple de réalisation.

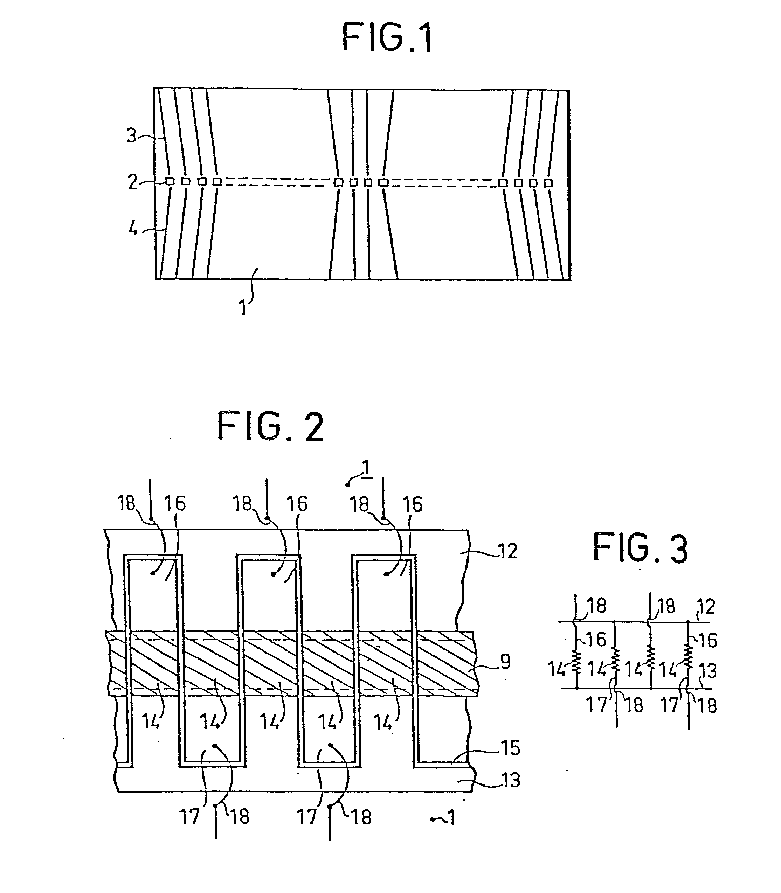

La figure 1 représente un élément de résistances en ligne pour barrette d'impression thermique selon l'art connu. A titre d'exemple, sans que ceci soit limitatif, cet élément de barrette a environ 5 cm de longueur et les résistances qui y sont déposées ont 1 mm de long sur 375 microns de largeur. Un tel élément comporte de l'ordre de 256 résistances.

Sur un substrat constitué par une plaquette de verre polioptique ou par une plaquette de céramique, ou encore d'autres matériaux suffisamment rigides, plans et isolants électriquement, sont déposés une série de résistances 2 et leurs connexions 3 et 4 qui permettent d'aller prendre sur les bords de la plaquette 1 des contacts électriques reliés aux circuits électroniques de commande. Chaque résistance 2 comporte une connexion d'entrée 3 et une connexion de sortie 4: il y a par conséquent un très grand nombre de connexions très rapprochées entre elles, ce qui pose ensuite des problèmes de reccordement électriques et de soudure.

En supprimant la moitié des connexions électriques telles que 3 ou 4 sur la figure 1, l'invention simplifie considérablement la réalisation et le cablage des résistances en série à très faible pas.

La figure 2 représente le dessin d'implantation de résistances en ligne selon un premier exemple de réalisation de l'invention.

Sur un substrat 1 sont déposées deux bandes métalliques conductrices 12 et 13; ces bandes sont séparées entre elles par un intervalle correpondant à l'implantation future des résistances en ligne. Puis est déposée une bande résistive continue 9 entre les deux plages conductrices 12 et 13 avec un chevauchement suffisant pour établir le contact électrique entre la bande 12 et la bande 9 d'une part, entre la bande 13 et la bande 9 d'autre part. La bande résistive continue 9 est alors découpée, par un faisceau laser de préférence, en résistances unitaires 14, le tracé du faisceau laser 15 étant une grecque qui découpe dans les plages métalliques 12 et 13 des plages 16 et 17 suffisamment grandes pour pouvoir y souder une connexion électrique. Après passage du faisceau laser la plage métallique 12 se trouve par consequent découpée en un peigne 12 et en un certain nombre de plages de connexion 16 qui se trouvent réunies électriquement à autant de fractions résistives 14 de la bande résistive 9 d'origine. De la même façon la plage conductrice 13 se trouve découpée en un peigne 13 et en un certain nombre de plages conductrices 17 qui se trouvent réunies électriquement à autant de fractions résistives 14 de la bande résistive d'origine 9, les palges résistives 16 et 17 étant alternées. Ces plages 16 et 17, et par conséquent la largeur des plages conductrices 12 et 13 à l'origine, sont avantageusement plus allongées dans la réalité que la représentation de la figure 2 de façon à éloigner de la partie centrale où se trouvent les résistances 14 les points de raccordement électriques. Le raccordement de chaque connexion 16 ou 17 à l'une des résistances en ligne peut se faire par des moyens connus de l'homme de l'art tel que par exemple par un circuit multicouche ou par une soudure par fil d'or ou d'aluminium, représenté sur la figure par les fils 18. L'important dans le système de raccordement a l'extérieur est que les connexions par fil 18 soient suffisamment éloignées de la barrette des résistances 14 pour qu'il n'y ait pas contact et frottement contre le papier s'il s'agit d'une tête d'impression thermique sur papier.

La figure 3 représente le schéma électrique équivalent du dessin d'implantation de la figure 2.

Selon ce schéma électrique, les résistances 14 sont groupées en deux séries alternées, une première série ayant la métallisation 12 comme point commun, une seconde série ayant la métallisation 13 comme point commun. La première série de résistances 14 est réunie à ses connexions de sortie par l'intermédiaire des plages de métallisation 17 et des fils 18. La seconde série de résistances 14, alternée avec la précédente, est réunie à ses connexions de sortie par les plages de métallisation 16 et les fils 18. Les résistances de la figure 3 sont en parallèles, néanmoins il s'agit toujours de résistances montées en ligne.

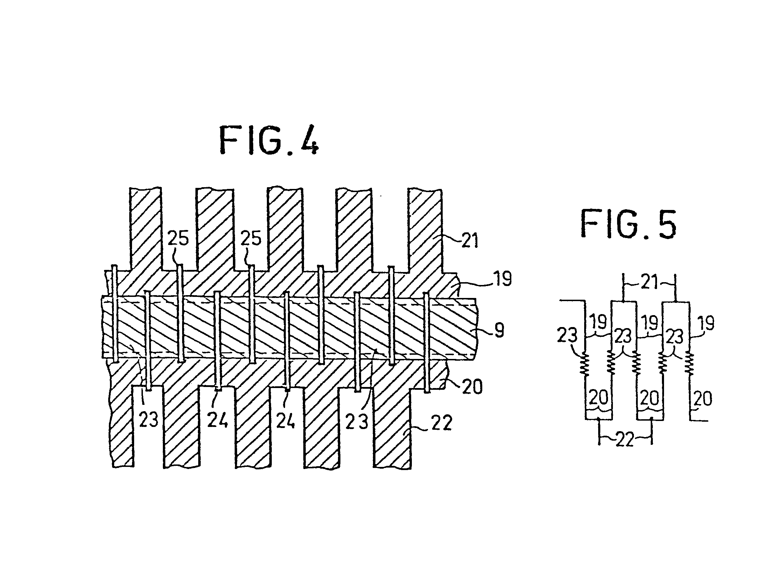

La figure 4 représente le dessin d'implantation de résistances en ligne selon un deuxième exemple de réalisation de l'invention.

Sur un substrat sont déposées deux bandes métalliques conductrices 19 et 20 laissant entre-elles un intervalle légèrement inférieur en dimension à la largeur de la bande résistive continue 9 qui sera déposée ultérieurement. Chacune des deux bandes métalliques conductrices 19 et 20 comporte un peigne de connexions dirigées vers les bords de la plaquette de substrat, connexions 21 sur la bande 19 et connexions 22 sur la bande 20. Les peignes 21 et 22 sont disposés en alternance de telle façon qu'une dent du peigne 21 correspond à un creux de peigne 22.

Une bande résistive continue 9 est ensuite déposée sur le substrat entre les deux bandes métalliques 19 et 20, moyennant cependant une légère superposition qui assure les prises de contact. La bande continue 9 est alors découpée en résistances élémentaires 23 par des entailles 24 et 25 dont chacune coupe la bande continue 9 plus l'une des deux bandes conductrices 19 ou 20. Ainsi, sur la figure 4, les entailles 24 coupent donc la bande résistive 9 et la bande continue 20 séparant ainsi la plage 20 en connexions isolées entre elles, chaque connexion 22 étant électriquement reliée à deux résistances 23. De la même façon les entailles 25 coupent toutes la bande résistive 9 et la bande métallique 19, séparant la plage 19 en connexions qui sont isolées entre elles, chaque connexion 21 correspondant à deux résistances 23. En outre les entailles 24 et 25 sont alternées.

Ainsi la bande continue 9 a été découpée en résistances élémentaires 23 dont chacune est en contact avec une connexion 21 et une connexion 22, chacune des connexions 21 et 22 étant en outre en contact avec les résistances voisines dans la barrette de résistances en ligne.

Les entailles 24 et 25 peuvent être faites par toute méthode à la portée de l'homme de l'art, mais étant donné que la bande résistive 9 a une certaine épaisseur, de façon à permettre l'impression thermique et le contact avec le papier qui défile contre la tête d'impression, et étant donné d'autre part que la composition de cette bande résistive 9 ne se prête pas bien à l'attaque chimique, ce qui par contre est le cas des bandes métalliques 19 et 20, la réalisation des entailles 24 et 25 se fait préférentiellement par un faisceau laser.

La figure 5 montre le schéma électrique équivalent de l'implantation des résistances en ligne selon le deuxième exemple de réalisation. Les résistances unitaires 23 y sont montées électriquement en série et elles sont reliées à un premier groupe de connexions 21 par l'intermédiaire des métallisations 19 et à un second groupe de connexions 22 par l'intermédiaire des métallisations 20. Ce sont, dans ce cas de figure 4 et du deuxième exemple de réalisation, l'enssemble des plages métalliques 19 et 20 et de la bande résistive qui sont découpées, préférentiellement par un faisceau laser.

A titre d'exemple non limitatif, chacune des résistances composant les résistances en ligne à très faible pas selon l'invention, a des dimensions de l'ordre de 125 µm de largeur et approximative-ment 1 mm de longueur.

Les résistances en ligne décrites au titre de cette invention sont principalement utilisées dans tous les dispositifs d'impression thermiques telles qu'imprimantes, telex, télématique, impression de tickets, imprimante portative etc. . . . ainsi que dans les enregistreurs rapides.

**Revendications**

1. Plaquette de résistances à très faible pas, groupées en deux séries interdigitées dans lesquelles elles sont connectées en parallèle, et munies d'autant de connexions électriques qu'il y a de résistances plus une, cette plaquette comprenant, supportées par un substrat isolant, rigide et plan, deux bandes métalliques (12, 13) parallèles et une bande résistive (9), disposée entre elles et en contact électrique avec elles, un sillon (15) en forme de grecque traversant de façon répétée la bande résistive (9) et pénétrant dans les bandes métalliques (12, 13), y changeant de direction et séparant ainsi des plages (16, 17) du reste des dites bandes (12, 13), lesdites plages (16, 17) servant de plages de connexions entre une résistance (14), découpée dans la bande résistive (9) par le sillon (15) en forme de grecque, et le circuit externe auquel elles sont reliées par un fil métallique (18) de connexion.

2. Plaquette de résistances à très faible pas, connectées en série et munies d'autant de connexions électriques qu'il y a de résistances plus une, cette plaquette comprenant, supportées par un substrat isolant, rigide et plan, deux bandes métalliques (19, 20) parallèles et une bande résistive (9), disposée entre elles et en contact électrique avec elles, une première pluralité de sillons (25), parallèles entre eux, traversant la bande résistive (9) et la première bande métallique (19), et une deuxième pluralité de sillons (24) parallèles entre eux, traversant la bande réistive (9) et la deuxième bande métallique (20), les sillons des première (25) et deuxième (24) pluralités de sillons étant interdigités, une résistance (23), ainsi découpée dans la bande résistive (9) par les sillons (24, 25) étant connectée au circuit externe par deux connexions métalliques (21, 22), respectivement en contact électrique avec les deux bandes métalliques (19, 20).

**Patentansprüche**

1. Widerstandsplättchen, dessen Widerstände mit sehr geringem Abstand in zwei verschachtelten Reihen gruppiert sind, in denen sie parallel geschaltet sind und die einen elektrischen Anschluß mehr besitzen, als Widerstände vorhanden sind, wobei dieses Plättchen auf einem starren und ebenen isolierenden Substrat zwei parallele Metallbänder (12, 13) und ein zwischen diesen liegendes und in elektrischem Kontakt mit diesen stehendes Widerstandsband (9) und eine Rille (15) in Mäanderform aufweist, die mehrfach das Widerstandsband (9) durchquert und in die Metallbänder (12, 13) eindringt und dort die Richtung ändert, wodurch Bereiche (16, 17) vom Rest der Bänder (12, 13) abgetrennt werden und diese Bereiche als Anschlußbereiche zwischen einem in dem Widerstandsband (9) durch die mäanderförmige Rille (15) ausgeschnittenen Widerstand (14) und dem äußeren Schaltkreis dienen, an den die Widerstände mithilfe eines metallischen Verbindungsdrahts (18) angeschlossen sind.

2. Widerstandsplättchen, dessen Widerstände einen sehr geringen Abstand besitzen und in Reihe geschaltet sind sowie einen elektrischen Anschluß mehr aufweisen, als Widerstände vorhanden sind, wobei dieses Plättchen auf einem starren und ebenen isolierenden Substrat zwei parallele Metallbänder (19, 20) und ein zwischen diesen liegendes und mit diesen in elektrischem Kontakt stehendes Widerstandsband (9), eine erste Vielzahl von zueinander parallelen Rillen (25), die die das Widerstandsband (9) und das erste Metallband (19) durchqueren, und eine zweite Vielzahl von zueinander parallelen Rillen (24) aufweist, die das Widerstandsband (9) und das zweite Metallband (20) durchqueren, wobei die Rillen der ersten Vielzahl (25) und die der zweiten Vielzahl (24) von Rillen verschachtelt sind und ein auf diese Weise im Widerstandsband (9) durch die Rillen (24, 25) ausgeschnittener Widerstand (23) an den äußeren Schaltkreis über zwei metallische Verbindungen (21, 22) angeschlossen ist, die in elektrischem Kontakt mit je einem der beiden metallischen Bänder (19, 20) stehen.

**Claims**

1. A resistor wafer having very low pitch resistors which are arranged in two interlaced series of parallelly connected resistors and are equipped with as many electrical connections as there are resistors, plus one, said wafer comprising on an insulating, rigid and flat support substrate two parallel metal bands (12, 13) and one resistor band (9) disposed between the metal bands and in electrical contact therewith, and comprising a groove (15) following the configuration of a Greek border, passing repetitively through the resistor band (9) and penetrating into the metal bands (12, 13), changing the direction in the metal bands and separating by this way areas (16, 17) from the remaining bands (12, 13), these areas (16, 17) constituting connection areas between one resistor (14) which is cut out of the resistor band (9) by the groove (15) following the configuration of a Greek border, and the outer circuit to which these resistors are connected through a metal connection wire (18).

2. A resistor wafer having very low pitch resistors which are connected in series and equipped with as many electrical connections as there are resistors, plus one, this wafer comprising on an insulating, rigid and flat support substrate two parallel metal bands (19, 20) and one resistor band (9) disposed between the metal bands and in electrical contact therewith, comprising moreover a first assembly of mutually parallel grooves (25) passing through the resistor band (9) and the first metal band (19), and a second assembly of mutually parallel grooves (24) passing through the resistor band (9) and the second metal band (20), the grooves of the first (25) and second assembly (24) of grooves being interlaced, a resistor (23) which has thus been cut out from the resistor band (9) by the grooves (24, 25) being connected to the outer circuit by two metal connections (21, 22) which are in electrical contact with the two metal bands (19, 20) respectively.

# FIG.1

# FIG. 2

# FIG. 3

# FIG.4

# FIG.5